# EUROPEAN PATENT SPECIFICATION

(11) **EP 4 083 401 B1**
(45) Date of publication and mention of the grant of the patent: **20.11.2024**
(21) Application number: 22168933.4
(22) Date of filing: 20.04.2022
(51) Int. Cl.: F01P 3/12, F02D 9/10, G11B 33/14, F02D 9/02

(54) **ELECTRONIC THROTTLE BODY**
ELEKTRONISCHES DROSSELKÖRPER
BOITIER PAPILLON ELECTRONIQUE

(30) Priority: 29.04.2021 CN 202110477409
(43) Date of publication of application: 02.11.2022
(73) Proprietor: Wuxi Valeo Automotive Components and Systems Co., Ltd., Wuxi Jiangsu 214101 (CN)
(72) Inventor: FAVELIER, Sylvain, 95892 CERGY PONTOISE (FR); CHIRON, Laurent, 95892 CERGY PONTOISE (FR); MAZET, Francois, 95892 CERGY PONTOISE (FR); RIDOLFI, Gabriel, 95892 CERGY PONTOISE (FR); YAN, Banghua, WUXI, 214101 (CN); KONG, Franck, WUXI, 214101 (CN)
(74) Representative: Valeo Powertrain Systems

(56) References cited:
- WO-A1-2011/009881
- CN-A- 108 638 433
- DE-A1- 102012 102 103
- US-A1- 2005 183 695
- US-A1- 2007 068 491

## Description

Embodiments of the present disclosure relate generally to plastic cover and a metal body for an electronic throttle. In addition, embodiments of the present disclosure further relate to an electronic throttle.

An electronic throttle is used to adjust the air input of a vehicle engine, and the control effect produced by an electronic throttle directly affects the combustion performance of fuel, the kinetic performance and comfort of a vehicle. Therefore, the electronic throttle is one of important components for a vehicle. Relevant prior art is WO2011/009881 A1 and US2007/068491 A1.

In some existing vehicles, the electronic throttle directly faces the turbocharger, and gas outputted by the turbocharger is directly delivered to the electronic throttle without being cooled. In this case, the temperature of the gas entering the electronic throttle is very high. In some other vehicles with compact engines, a high-temperature heat source element in the engine, for example, a gasoline particulate filter (GPF) on the exhaust side of the engine, is arranged adjacent to the electronic throttle. The ambient temperature of the electronic throttle is very high due to the thermal radiation emitted by a nearby high-temperature heat source element.

In order to protect a temperature-sensitive electrical element, for example a sensor, in an electronic throttle from a high ambient temperature and a high intake air temperature, an electrical element is usually mounted in an electronic throttle by a plastic cover with a relatively low thermal conductivity. Commonly used plastic covers are made of a PPS material to provide effective thermal shielding against a high ambient temperature and a high intake air temperature. Usually, electrical elements such as sensors are mounted on a plastic cover and leads are embedded directly within the plastic cover through a lead frame, for example, as disclosed in publication CN110375699 A, after placing an angle sensor assembly inside the plastic cover mould, the plastic cover mould in which the angle sensor is placed is injection moulded so that the plastic cover pins, angle sensor and angle sensor base are completely encased in the plastic cover mould. A sensor is, for example, a Hall effect element for measuring the rotation angle of a valve shaft of an electronic throttle. In this case, heat is transferred from the plastic cover and lead frame to the sensor, and thus the temperature at the sensor increases with the ambient temperature and intake air temperature. Generally, a sensor can operate properly below 160°C. Therefore, an electronic throttle should not be subjected to an excessively high ambient temperature or an excessively high intake air temperature for a long time. Otherwise, the sensor will be unable to operate, or even fail or be permanently damaged, and consequently the electronic throttle will fail to operate properly at a high ambient temperature and intake air temperature, which will affect the service life of the electronic throttle.

Therefore, it has become an urgent problem to be solved in the art to provide an electronic throttle that can ensure the proper operation of electrical elements at relatively high ambient temperature and intake air temperature.

The objective of the present invention is to provide an electronic throttle comprising a plastic cover and a metal body according to independent claim 1 being capable of ensuring that an electrical element operates properly at relatively high ambient temperature and intake air temperature, having a long service life and a simple structure, and being inexpensive.

The present invention provides a plastic cover able to cooperate with a metal body to form a closed electrical chamber, wherein an electrical element is arranged on the plastic cover and located in the electrical chamber, and a plurality of separate support protrusions are provided on an inner surface of the plastic cover to support the electrical element and form, between the plastic cover and the electrical element, a passage for the circulation of a convection gas in the electrical chamber.

In one embodiment, a retaining wall is provided on the inner surface of the plastic cover on the side of a contact of the electrical element, and is open on the other side of the electrical element.

In one embodiment, the plastic cover is provided with a fluid guiding feature portion, which is arranged adjacent to the electrical element and configured to guide a convection gas in the electrical chamber to flow through the electrical element.

In one embodiment, the fluid guiding feature portion comprises a plurality of guide strips provided on the inner surface of the plastic cover, wherein a guide passage tapering towards the electrical element is formed between adjacent guide strips.

In one embodiment, the fluid guiding feature comprises at least one concave guide passage provided on the inner surface of the plastic cover, the guide passage tapering towards the electrical element.

In one embodiment, the plastic cover comprises a lead frame integrally injection-moulded therewith, and the outer surface of the portion of the plastic cover that corresponds to the lead frame is recessed.

In one embodiment, the plastic cover is made of a thermoplastic material comprising polybutylene terephthalate (PBT), polyphenylene sulphide (PPS), or a combination thereof.

In one embodiment, the electrical element is a sensor provided in a position corresponding to the end of a valve shaft of the electronic throttle.

In one embodiment, a distance from the electrical element to the inner surface of the portion of the plastic cover that corresponds to the electrical element is 0.5 mm to 10 mm.

The present invention also provides a metal body able to cooperate with a plastic cover with one of the above features, the metal body having a gas passage and a cooling pipe arranged in the metal body, at least one protrusion extending beyond a planar surface cooperating with the plastic cover, the at least one protrusion is provided on the metal body in a position corresponding to the cooling pipe.

In one embodiment, at least one of the protrusions extends to the plastic cover.

In one embodiment, a ratio of the height of the metal main body to the height of the electronic throttle is at least 85%, wherein, optionally, the height of the electronic throttle is approximately 122 mm, and the height of the metal main body may be approximately 102 mm.

Advantages and objectives of the present invention will become more readily comprehensible from preferred embodiments of the present invention as described in detail below in conjunction with the drawings. In order to better illustrate the relationships among the components shown in the drawings, the drawings are not drawn to scale. Among the drawings,
Fig. 1 is an overall schematic diagram of a conventional electronic throttle;
Fig. 2 is a schematic diagram of the interior of a plastic cover of a conventional electronic throttle;
Fig. 3 is an overall schematic diagram of an electronic throttle for a vehicle according to an embodiment of the present invention;
Fig. 4 is a schematic diagram of a metal main body of an electronic throttle for a vehicle according to an embodiment of the present invention;
Fig. 5 is a schematic diagram of a plastic cover for an electronic throttle for a vehicle according to an embodiment of the present invention;
Fig. 6 is a partial enlarged view of the plastic cover according to Fig. 5, showing the electrical element mounted on the inside of the plastic cover; and
Fig. 7 is an enlarged partial view of the plastic cover according to Fig. 5, showing the case in which the electrical element has been removed.

In order to make the objectives, technical solutions and advantages of the present invention clearer, technical solutions provided by embodiments of the present invention will be clearly and completely described below with reference to the drawings of specific embodiments of the present invention. In the drawings, the same reference numeral denotes the same component. It should be noted that the described embodiments are some, but not all, embodiments of the present application. Any embodiments obtained by those of ordinary skill in the art on the basis of the described embodiments of the present invention without making inventive efforts fall into the scope of protection of the present invention.

Unless otherwise defined, the technical terms or scientific terms used herein shall have the common meanings as understood by those of ordinary skill in the art to which the present invention belongs. The terms "first", "second" and similar terms used in the description and claims of the present invention patent application, rather than denoting any sequences, quantities, or orders of importance, are only used to distinguish between different components. Likewise, terms such as "a" and "one" do not necessarily represent a quantity limit. "Comprise", "include", "have" or any other similar term means that the element or object preceding the term covers the elements or objects and equivalents thereof listed after the term but does not exclude other elements or objects. A term like "connected" or "linked", rather than being limited to the physical or mechanical connection or link shown in a drawing, may include a connection or link equivalent thereto, irrespective of whether it is direct or indirect. "Upper", "lower", "left", "right", etc. are only used to indicate a relative positional relationship, and when the absolute position of the described object has changed, the relative positional relationship may also change accordingly.

An electronic throttle is used to adjust the air input of a vehicle engine, and typically comprises a metal main body and a plastic cover that are joined together, for example, by a clip. The metal main body and the plastic cover jointly form a closed chamber. The metal main body is provided with a gas passage for gas circulation and a cooling pipe for cooling a fluid flow. For example, air flows into the engine through the gas passage. A cooling fluid, for example, water, circulates in the cooling pipe to cool the electronic throttle. Due to the high ambient temperature and intake air temperature, the temperature of the metal main body of the electronic throttle is usually higher than that of the plastic cover, and thus a convective gas then results from the temperature difference in the closed chamber.

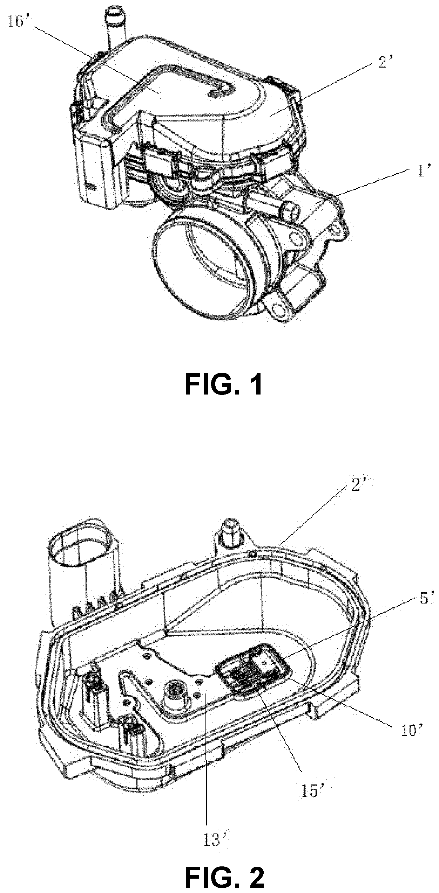

Fig. 1 shows the appearance of a conventional electronic throttle, which comprises a metal housing 1' located in a lower part of the drawing and a plastic cover 2' located in an upper part of the drawing. Fig. 2 is a schematic diagram of the interior of the plastic cover 2' of a conventional electronic throttle. As shown in Fig. 2, the plastic cover 2' is provided with a lead frame 13', and leads for electrically connecting an electrical element 5' in the plastic cover 2' to a device, for example, an external power source, are arranged in the lead frame. Referring to Fig. 1, the outer surface of a portion 16' of the plastic cover 2' corresponding to the lead frame 13' is substantially flush with the outer surfaces of other portions of the plastic cover. In addition, as shown in Fig. 2, the electrical element 5' is directly arranged on the inner surface of the plastic cover 2', and a protruding retaining wall 10' is arranged around the electrical element 5'. A contact 15' (for example, a metal pin) of the electrical elements 5' is electrically connected to a contact of the lead by soldering, and then glue is filled within the retaining wall to avoid short circuits. With such an electronic throttle, since the area of contact between the electrical element 5' and the plastic cover 2' is large and the heat transfer area for heat exchange with a convective gas in the closed chamber is small, the temperature at the electrical element is too greatly affected by high ambient temperature and intake air temperature to be maintained at a normal operating temperature. Therefore, the electronic throttle and plastic cover shown in Fig. 1 and 2 cannot function properly at high ambient and intake air temperatures, especially at an ambient temperature up to 200°C and, when the vehicle engine runs at full load, an intake air temperature up to 210°C.

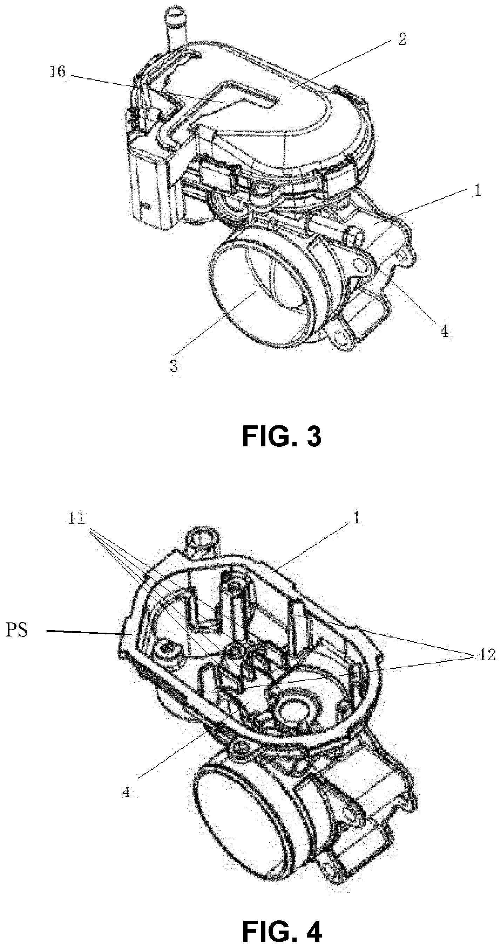

Fig. 3 to 7 show examples of an electronic throttle for a vehicle of the present invention, which deliver improved performance compared with the examples shown in Fig. 1 and 2, capable of maintaining the temperature at an electrical element below the normal operating temperature.

As shown in Fig. 3, an electronic throttle of the present invention comprises a metal main body 1 and a plastic cover 2. The metal main body 1 may be made of an aluminium alloy. A gas passage 3 and a cooling pipe 4 are arranged in the metal main body 1. For example, air enters the engine of the vehicle through the gas passage 3. A cooling fluid, for example, water, circulates in the cooling pipe 4 to carry heat away from the metal housing. The plastic cover 2 may be made of PPS, or PBT when the operating temperature is relatively low. The plastic cover 2 is mounted on the metal main body 1, for example, being fixed on the metal main body by a clip and forming a closed electrical chamber with the metal main body 1. In addition, the electronic throttle further comprises a motor, a gear assembly, a valve shaft, a valve plate, etc., which are arranged therein, and none of these elements is shown in Fig. 3. The gear assembly may rotate when driven by the motor, the valve shaft may rotate when driven by the gear assembly, and the valve plate is arranged on the valve shaft and can rotate with the valve shaft, so that the gas cross section of the gas passage 3 is controllable to regulate the gas flow into the engine.

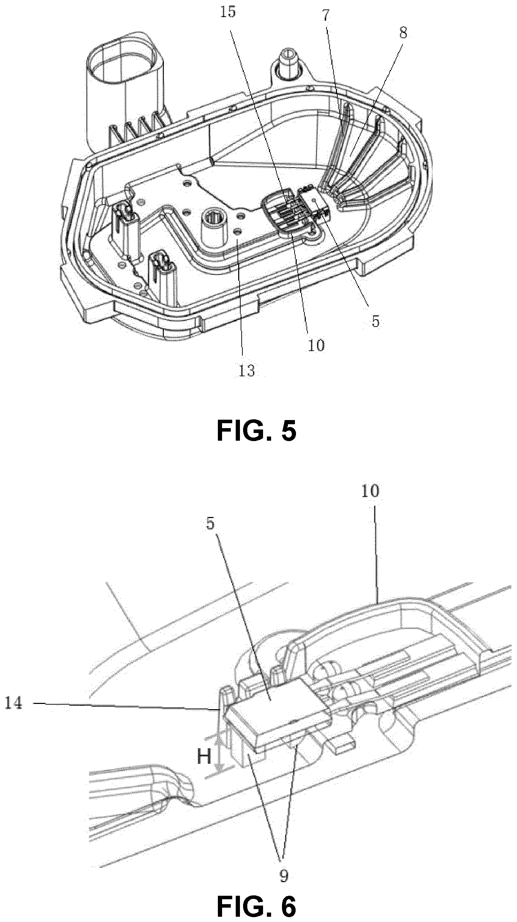

In order to measure the rotation angle of the valve shaft, thereby controlling the air input of the engine, an electrical element 5, for example a sensor, is arranged in the electrical chamber. As shown in Fig. 5, the electrical element 5 is arranged on the plastic cover 2. For example, the electrical element 5 is a Hall effect element arranged in a position corresponding to the end of the valve shaft of the electronic throttle, which facilitates the measurement of the rotation angle of the valve shaft.

As shown in Fig. 4, at least one protrusion 11, 12 facing the plastic cover 2 is arranged on the metal main body 1 in a position corresponding to the cooling pipe 4. The at least one protrusion 11, 12 is extending beyond a planar surface PS cooperating with the plastic cover 2. In other words, one of the protrusion 11, 12 extend into the electrical chamber.

At least one first protrusion 12 of the at least one protrusion extends to the plastic cover 2 to transfer heat away from the plastic cover 2 by a cooling fluid in the cooling pipe 4. Generally, the first protrusion 12 connects the cooling pipe 4 of the metal main body 1 to the plastic cover 2 to form an effective heat transfer path. The first protrusion 12 may be made of the same material, for example, an aluminium alloy, as the metal main body 1. At least one second protrusion 11 of the at least one protrusion forms a passage for guiding a convective gas in the electrical chamber, so that the temperature of the convective gas is reduced by the cooling fluid in the cooling pipe 4. A position of the second protrusion 11 is designed such that a convective gas formed in the electrical chamber flows through both the electrical element and the cooling pipe. For example, the second protrusion 11 is located below the electrical element 5, but does not need to be perfectly aligned with the electrical element 5 in the height direction of the electronic throttle. The second protrusion 11 may also be made of the same material, for example, an aluminium alloy, as the metal main body 1.

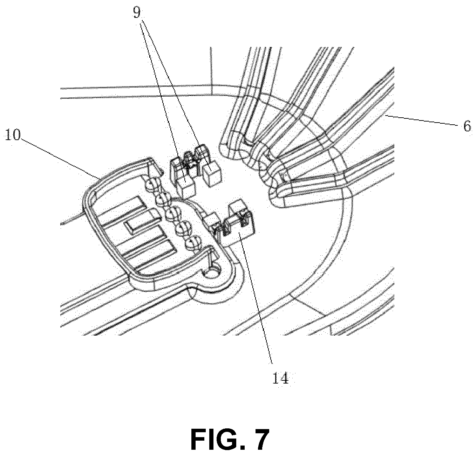

As shown in Fig. 5 and 7, an electronic throttle of the present invention further comprises a fluid guiding feature 6, which is arranged adjacent to the electrical element 5 and configured to guide a convective gas in the electrical chamber to flow through the electrical element 5. With this structure, heat may be dissipated more efficiently at the electrical element.

For example, as shown in Fig. 5, the fluid guiding feature 6 comprises a plurality of guide strips 7 arranged on the inner surface of the plastic cover 2, and a guide passage 8 tapering towards the electrical element 5 is formed between adjacent guide strips. The guide strip 7 may be made of a material which is the same as or different from the plastic cover 2, and the guide strip 7 may be arranged on the inner surface of the plastic cover 2 in various manners, such as bonding and integral moulding. Alternatively, the fluid guiding feature 6 comprises at least one concave guide passage arranged on the inner surface of the plastic cover 2, the guide passage tapering towards the electrical element. In this case, the fluid guiding feature 6 comprises only guide passages but no guide strips.

The above-described guide passage tapering towards the electrical element utilizes the Venturi effect, so that a convective gas in the electrical chamber flows through the electrical element at a higher flow rate, thereby improving the effect of cooling the electrical element.

As shown in Fig. 5 to 7, an electrical element in an electronic throttle of the present invention is supported on the inner side of the plastic cover 2 by a plurality of separate support protrusions 9, 14, the plurality of separate support protrusions 9, 14 being arranged on the inner surface of the plastic cover 2, that is, the surface of the plastic cover 2 facing the electrical chamber. For example, the support protrusions 9, 14 may be made of the same material as the plastic cover 2.

As shown in Fig. 6 and 7, a plurality of separate first support protrusions 9 located under the electrical element 5 keep a distance between the electrical element 5 and the inner surface of the portion of the plastic cover 2 that corresponds to the electrical element, so that a sufficiently large passage for the circulation of a convective gas in the electrical chamber is formed between the electrical element 5 and the plastic cover 2, wherein, in one embodiment, the height H of the passage for the circulation of a convective gas with respect to the inner surface of the portion of the plastic cover 2 that corresponds to the electrical element may be 0.5 mm to 10 mm, which means that the distance between the electrical element 5 and the inner surface of the portion of the plastic cover 2 that corresponds to the electrical element is approximately 0.5 mm to 10 mm. With such a structure, the effect of heat convection on the surface of the electrical element 5 is enhanced, while the amount of heat transferred from the plastic cover 2 to the electrical element 5 is reduced.

For example, the number of the plurality of separated first support protrusions 9 is four, and they are located in positions corresponding to the four corners of the electrical element 5. The number, forms and positions of the first support protrusions of the present invention are not limited to those shown in Fig. 7, as long as a passage for the circulation of a convective gas in the electrical chamber may be formed between the electrical element 5 and the plastic cover 2. In another example, the number of the first support protrusions 9 may be two, wherein, for example, they are respectively located at the two first support protrusions as shown in the upper part of Fig. 7 and the two first support protrusions as shown in the lower part of Fig. 7.

Referring to Fig. 6 and 7 again, the two second support protrusions 14 located on either side of the electrical element 5 are spacing portions, and the electrical element 5 is fixed on the plastic cover 2 by the spacing portions. For example, the electrical element 5 is snapped between two second support protrusions 14. For example, the electrical element 5 is welded on the second support protrusions 14 by spot welding. The point contact between the second support protrusions 14 and the electrical element 5 allows a reduction of the heat transferred from the plastic cover 2 to the electrical element 5. The number, forms and positions of the second support protrusions of the present invention are not limited to those shown in Fig. 7.

As shown in Fig. 5 to 7, a retaining wall 10 is provided on the inner surface of the plastic cover 2 on the side of a contact 15 of the electrical element 5, and is open on the other side of the electrical element 5. Specifically, the retaining wall 10 is provided only on the side of the contact 15 of the electrical element 5, and no retaining wall is provided on the side of the electrical element 5 adjacent to the fluid guiding feature 6. With such a structure, an airflow guided to the electrical element 5 by the fluid guiding feature 6 may flow without obstruction to the electrical element 5 and further flow through the upper surface (the surface facing away from the plastic cover 2) and the lower surface (the surface facing the plastic cover 2) of the electrical element 5, so that the area of contact with the convective gas increases to enhance the heat exchange effect. In addition, due to the retaining wall 10 on the side of the contact 15, it is still possible to fill glue between the retaining wall and the electrical element to avoid short circuits. For example, the retaining wall 10 surrounds the contact 15 and has an opening through which the contact 15 may extend, as shown in Fig. 5 and 7, and the retaining wall 10 has, for example, a rectangular shape and is open on one long side.

Referring to Fig. 5, the plastic cover 2 comprises a lead frame 13 integrally injection-moulded therewith, and leads for electrically connecting the contact 15 of the electrical element 5 to an external electrical component are arranged in the lead frame. The lead frame 13 protrudes from above the inner surface of the plastic cover 2. It is clear from Fig. 3 that compared with the outer surface of the cover of the electronic throttle shown in Fig. 1, the outer surface of the portion 16 of the plastic cover 2 of the present invention that corresponds to the lead frame 13 is recessed. With this structure, the heat transferred from the external environment to the lead frame and the leads and further to the electrical element may be reduced, so that the impact of the ambient temperature on the lead frame, the leads, and the electrical element is mitigated.

As shown in Fig. 3, a ratio of the height of the metal main body 1 to the height of the electronic throttle of the present invention is at least 85%, especially 85%. By increasing the height ratio of the metal main body, the metal area for heat transfer is increased, and the volume of convective gas used for heat transfer in the electron chamber is increased, which provides a better heat transfer effect. In one embodiment, the height of the electronic throttle is approximately 122 mm, and the height of the metal main body may be approximately 102 mm, wherein it is understandable that "approximately" is intended to indicate that the height of the electronic throttle and the metal main body need not be exactly 122 mm or 102 mm, which means that rational errors due to design requirements, processing technology, material properties, etc. are allowable.

With the various structures as described above, an electronic throttle of the present invention can ensure the normal operation of an electrical element at high ambient temperature and intake air temperature, wherein, especially, the temperature at an electrical element in the electronic throttle remains below 160°C when the ambient temperature is as high as 200°C and, as the vehicle engine is running at full load, the intake air temperature is as high as 210°C. Therefore, an electronic throttle of the present invention has a long service life and a simple structure and is inexpensive.

In addition, the technical features disclosed above are not limited to the disclosed combinations with other features, and those of ordinary skill in the art can also bring about other combinations of the technical features according to objectives of the present invention, thereby achieving objectives of the present invention.

## Claims

1. An electronic throttle comprising a plastic cover (2) and a metal body (1), the plastic cover (2) is cooperated with the metal body (1) to form a closed electrical chamber, wherein an electrical element (5) is arranged on the plastic cover (2) and located in the electrical chamber, and a plurality of separate support protrusions (9, 14) are provided on an inner surface of the plastic cover (2) to support the electrical element (5) and form, between the plastic cover and the electrical element, a passage for the circulation of a convection gas in the electrical chamber, wherein the metal body (1) having a gas passage (3) and a cooling pipe (4) arranged in the metal body (1), at least one protrusion (11, 12) extending beyond a planar surface (PS) cooperating with the plastic cover (2), the at least one protrusion (11, 12) is provided on the metal body (1) in a position corresponding to the cooling pipe (4).

2. Electronic throttle according to claim 1, **characterized in that** a retaining wall (10) is provided on the inner surface of the plastic cover (2) on one side of a contact of the electrical element (5), and is open on the other side of the electrical element (5).

3. Electronic throttle according to claim 1 or 2, **characterized in that** the plastic cover (2) is provided with a fluid guiding feature portion (6), which is arranged adjacent to the electrical element (5) and configured to guide a convection gas in the electrical chamber to flow through the electrical element (5).

4. Electronic throttle according to claim 3, **characterized in that** the fluid guiding feature portion (6) comprises a plurality of guide strips (7) provided on the inner surface of the plastic cover (2), wherein a guide passage (8) tapering towards the electrical element is formed between adjacent guide strips.

5. Electronic throttle according to claim 3, **characterized in that** the fluid guiding feature (6) comprises at least one concave guide passage provided on the inner surface of the plastic cover (2), the guide passage tapering towards the electrical element.

6. Electronic throttle according to any of claims 1 to 5, **characterized in that** the plastic cover (2) comprises a lead frame (13) integrally injection-moulded therewith, and **in that** the outer surface of the portion of the plastic cover (2) that corresponds to the lead frame (13) is recessed.

7. Electronic throttle according to any of claims 1 to 6, **characterized in that** the electrical element (5) is a sensor.

8. Electronic throttle according to one of the preceding claims, **characterized in that** a distance from the electrical element (5) to the inner surface of the portion of the plastic cover (2) that corresponds to the electrical element is 0.5 mm to 10 mm.

## Patentansprüche

1. Elektronische Drosselklappe, die eine Kunststoffabdeckung (2) und einen Metallkörper (1) umfasst, wobei die Kunststoffabdeckung (2) mit dem Metallkörper (1) zusammenwirkt, um eine geschlossene elektrische Kammer zu bilden, wobei ein elektrisches Element (5) auf der Kunststoffabdeckung (2) angeordnet und sich in der elektrischen Kammer befindet und eine Vielzahl von separaten Stützvorsprüngen (9, 14) auf einer Innenfläche der Kunststoffabdeckung (2) vorgesehen sind, um das elektrische Element (5) abzustützen und zwischen der Kunststoffabdeckung und dem elektrischen Element einen Kanal für die Zirkulation eines Konvektionsgases in der elektrischen Kammer zu bilden, wobei der Metallkörper (1) einen Gaskanal (3) und ein im Metallkörper (1) angeordnetes Kühlrohr (4) aufweist, wobei mindestens ein Vorsprung (11, 12) über eine ebene Oberfläche (PS) hinausragt, die mit der Kunststoffabdeckung (2) zusammenwirkt, wobei der mindestens eine Vorsprung (11, 12) an dem Metallgehäuse (1) in einer Position vorgesehen ist, die dem Kühlrohr (4) entspricht.

2. Elektronische Drosselklappe nach Anspruch 1, **dadurch gekennzeichnet, dass** auf der Innenfläche der Kunststoffabdeckung (2) eine Haltewand (10) auf einer Seite eines Kontakts des elektrischen Elements (5) vorgesehen ist und auf der anderen Seite des elektrischen Elements (5) offen ist.

3. Elektronische Drosselklappe nach Anspruch 1 oder 2, **dadurch gekennzeichnet, dass** die Kunststoffabdeckung (2) mit einem fluidführenden Merkmalsabschnitt (6) versehen ist, der neben dem elektrischen Element (5) angeordnet und dazu ausgelegt ist, ein Konvektionsgas in der elektrischen Kammer zu leiten, um durch das elektrische Element (5) zu strömen.

4. Elektronische Drosselklappe nach Anspruch 3, **dadurch gekennzeichnet, dass** der Fluidführungsmerkmalabschnitt (6) eine Vielzahl von Führungsstreifen (7) umfasst, die an der Innenfläche der Kunststoffabdeckung (2) vorgesehen sind, wobei ein sich zum elektrischen Element hin verjüngender Führungskanal (8) zwischen benachbarten Führungsstreifen ausgebildet ist.

5. Elektronische Drosselklappe nach Anspruch 3, **dadurch gekennzeichnet, dass** das Fluidführungsmerkmal (6) mindestens einen konkaven Führungskanal umfasst, der an der Innenfläche der Kunststoffabdeckung (2) vorgesehen ist, wobei sich der Führungskanal zum elektrischen Element hin verjüngt.

6. Elektronische Drosselklappe nach einem der Ansprüche 1 bis 5, **dadurch gekennzeichnet, dass** die Kunststoffabdeckung (2) einen damit integral spritzgegossenen Leiterrahmen (13) umfasst, und dass die Außenfläche des Abschnitts der Kunststoffabdeckung (2), der dem Leiterrahmen (13) entspricht, vertieft ist.

7. Elektronische Drosselklappe nach einem der Ansprüche 1 bis 6, **dadurch gekennzeichnet, dass** das elektrische Element (5) ein Sensor ist.

8. Elektronische Drosselklappe nach einem der vorhergehenden Ansprüche, **dadurch gekennzeichnet, dass** ein Abstand von dem elektrischen Element (5) zur Innenfläche des dem elektrischen Element entsprechenden Abschnitts der Kunststoffabdeckung (2) 0,5 mm bis 10 mm beträgt.

## Revendications

1. Accélérateur électronique comprenant un cache en plastique (2) et un corps métallique (1), le cache en plastique (2) coopérant avec le corps métallique (1) pour former une chambre électrique fermée, dans lequel un élément électrique (5) est agencé sur le cache en plastique (2) et situé dans la chambre électrique, et une pluralité de parties saillantes de support (9, 14) séparées sont fournies sur une surface interne du cache en plastique (2) pour supporter l'élément électrique (5) et former, entre le cache en plastique et l'élément électrique, un passage pour la circulation d'un gaz de convection dans la chambre électrique, dans lequel le corps métallique (1) a un passage de gaz (3) et un tuyau de refroidissement (4) agencé dans le corps métallique (1), au moins une partie saillante (11, 12) s'étendant au-delà d'une surface plane (PS) coopérant avec le cache en plastique (2), l'au moins une partie saillante (11, 12) étant fournie sur le corps métallique (1) dans une position correspondant au tuyau de refroidissement (4).

2. Accélérateur électronique selon la revendication 1, **caractérisé en ce qu'**une paroi de retenue (10) est fournie sur la surface interne du cache en plastique (2) sur un côté d'un contact de l'élément électrique (5), et est ouverte sur l'autre côté de l'élément électrique (5).

3. Accélérateur électronique selon la revendication 1 ou 2, **caractérisé en ce que** le cache en plastique (2) est pourvu d'une partie d'élément de guidage de fluide (6), qui est agencée de manière adjacente à l'élément électrique (5) et configurée pour guider un gaz de convection dans la chambre électrique pour qu'il s'écoule à travers l'élément électrique (5).

4. Accélérateur électronique selon la revendication 3, **caractérisé en ce que** la partie d'élément de guidage de fluide (6) comprend une pluralité de bandes de guidage (7) fournies sur la surface interne du cache en plastique (2), dans lequel un passage de guidage (8) s'effilant vers l'élément électrique est formé entre des bandes de guidage adjacentes.

5. Accélérateur électronique selon la revendication 3, **caractérisé en ce que** l'élément de guidage de fluide (6) comprend au moins un passage de guidage concave fourni sur la surface interne du cache en plastique (2), le passage de guidage s'effilant vers l'élément électrique.

6. Accélérateur électronique selon l'une quelconque des revendications 1 à 5, **caractérisé en ce que** le cache en plastique (2) comprend une grille de connexion (13) moulée par injection d'un seul tenant avec celui-ci, et **en ce que** la surface externe de la partie du cache en plastique (2) qui correspond à la grille de connexion (13) est évidée.

7. Accélérateur électronique selon l'une quelconque des revendications 1 à 6, **caractérisé en ce que** l'élément électrique (5) est un capteur.

8. Accélérateur électronique selon l'une des revendications précédentes, **caractérisé en ce qu'**une distance de l'élément électrique (5) à la surface interne de la partie du cache en plastique (2) qui correspond à l'élément électrique est de 0,5 mm à 10 mm.
